Europäisches Patentamt

European Patent Office

Office européen des brevets

(11) Numéro de publication : **0 141 715 B1**

# FASCICULE DE BREVET EUROPÉEN

(45) Date de publication du fascicule du brevet : 04.05.88

(51) Int. Cl.⁴ : **H 03 F 1/32, H 04 N 5/38**

(21) Numéro de dépôt : **84402078.4**

(22) Date de dépôt : **16.10.84**

(54) **Dispositif de précorrection automatique des non-linéarités dans une chaîne d'amplification de puissance, et son application à un émetteur de télévision.**

(30) Priorité : 21.10.83 FR 8316795

(43) Date de publication de la demande : 15.05.85 Bulletin 85/20

(45) Mention de la délivrance du brevet : 04.05.88 Bulletin 88/18

(84) Etats contractants désignés :
BE CH DE LI LU

(56) Documents cités :
FR-A- 2 275 065
US-A- 3 825 843

(73) Titulaire : **THOMSON-LGT LABORATOIRE GENERAL DES TELECOMMUNICATIONS**
51, boulevard de la République
F-78400 Chatou (FR)

(72) Inventeur : **Corbel, Philippe**
**THOMSON-CSF SCPI 173, bld Haussmann**
**F-75379 Paris Cedex 08 (FR)**
Inventeur : **Allanic, Michel**
**THOMSON-CSF SCPI 173, bld Haussmann**
**F-75379 Paris Cedex 08 (FR)**

(74) Mandataire : **Turlèque, Clotilde et al**
**THOMSON-CSF SCPI 19, avenue de Messine**
**F-75008 Paris (FR)**

EP 0 141 715 B1

Jouve, 18, rue St-Denis, 75001 Paris, France

## Description

L'invention se rapporte à un dispositif de précorrection automatique des non-linéarités, inter-modulation et/ou transmodulation, dans une chaîne d'amplification de puissance. Son domaine est particulièrement celui des émetteurs et réémetteurs de télévision, dans lesquels le signal à émettre est un signal modulé en amplitude. En effet, lorsque les amplificateurs de puissance présentent des non-linéarités, la modulation d'amplitude du signal à transmettre subit une distorsion qui nuit à la qualité du signal reçu.

Dans les émetteurs de télévision comportant deux chaînes d'amplification séparées, l'une destinée à l'amplification du signal vidéo image, l'autre destinée à l'amplification du signal audiofréquence, les défauts créés par les non-linéarités des amplificateurs se traduisent par une intermo-dulation du signal amplifié, c'est-à-dire qu'un signal parasite est superposé au signal de modulation à transmettre. Dans les émetteurs de télévision en voie commune, c'est-à-dire dans lesquels le signal vidéo fréquence et le signal audio fréquence, tous deux modulés en amplitude, sont transmis et amplifiés simultanément, les non-linéarités dans la chaîne d'amplification se traduisent d'une part par un signal parasite d'intermo-dulation sur chacune des porteuses modulées, et d'autre part par un signal parasite de transmodulation dû au transfert de modulation de chacune des porteuses sur l'autre.

Les critères de qualité des émetteurs ou réémetteurs de télévision sont tels que le bruit c'est-à-dire les signaux parasites doivent être à un niveau de 60 décibels au-dessous du signal utile. Or, lorsqu'aucune correction n'est appliquée, le niveau de bruit n'est qu'à 20 décibels au-dessous du signal utile. En conséquence, il est absolument indispensable de mettre en œuvre dans ces systè-mes des moyens de correction de non-linéarités.

Le brevet français n° 2 275 065 au nom du Demandeur, décrit un circuit de correction particulièrement adapté à la correction des non-linéarités du troisième ordre dans un émetteur à voies séparées. Dans ce circuit, les signaux à l'entrée et à la sortie de la chaîne d'amplification sont détectés, le signal à la sortie de la chaîne étant de plus divisé par un coefficient égal à la partie linéaire du gain de la chaîne d'amplification, ces deux signaux étant comparés dans un soustrac-teur qui délivre un signal d'erreur à la pulsation de la sous-porteuse à corriger ; ce signal d'erreur est ensuite additionné au signal d'entrée dans un circuit de précorrection précédant les étages d'amplification. Un tel dispositif de précorrection est bien adapté à la correction de l'intermodula-tion, mais il ne permet pas de corriger convenablement la distorsion due à la transmodulation d'une porteuse sur l'autre dans un émetteur à voie commune. En effet, un tel système permet de corriger convenablement une sous-porteuse à puissance constante. Mais lorsque la sous-porteuse à corriger est elle-même modulée en amplitude, et a donc une puissance instantanée variable, ce circuit de correction ne permet pas de la corriger dans toute sa plage de variation.

L'invention a pour objet un dispositif de correction automatique des non-linéarités dans une chaîne d'amplification de puissance, en particulier les non-linéarités dues à la transmodulation dans un émetteur de télévision à voie commune, qui permet d'améliorer la qualité des équipements et qui n'a pas les limitations du système décrit ci-dessus.

Suivant l'invention, un dispositif de précorrection de non-linéarités dues à la transmodulation dans une chaîne d'amplification de puissance en voie commune de plusieurs porteuses modulées en amplitude, comportant deux voies en dérivation respectivement connectées en amont et en aval de la chaîne d'amplification pour prélever une partie du signal transmis, chacune comportant un circuit de détection recevant le signal prélevé, la voie en dérivation branchée à la sortie de la chaîne d'amplification comportant en outre un atténuateur ayant un coefficient d'atténuation égal à la partie du gain de la chaîne indépendante du signal d'entrée, est caractérisé en ce que la voie en dérivation branchée à la sortie de la chaîne d'amplification en voie commune comporte en outre un circuit de filtrage de la porteuse à corriger, la voie de dérivation en amont de la chaîne d'amplification étant branchée dans la voie de transmission de cette même porteuse, avant sommation des composantes à amplifier en voie commune et en ce que les voies en dérivation sont reliées aux entrées d'un diviseur analogique dont la sortie est couplée à l'entrée de commande d'un circuit de précorrection à atténuation ajustable, ce circuit de précorrection étant placé en amont de la dérivation précédant la chaîne d'amplification.

L'invention a également pour objet l'application de ce dispositif à un émetteur de télévision.

L'invention sera mieux comprise et d'autres caractéristiques apparaîtront à l'aide de la description qui suit en référence aux figures annexées :

— la figure 1 est un schéma synoptique d'un mode de réalisation du dispositif de correction automatique suivant l'invention ;

— les figures 2 et 3 sont des schémas de détails de certains éléments du dispositif représenté sur la figure 1 ;

— la figure 4 est un schéma synoptique d'un second mode de réalisation du dispositif de correction suivant l'invention.

Comme indiqué ci-dessus, lorsque deux signaux à des sous-porteuses différentes sont transmis simultanément à une chaîne d'amplification en vue d'y être amplifiés ensemble, et lorsque la chaîne d'amplification n'est pas parfaitement linéaire, ce qui est le cas lorsque les amplificateurs sont utilisés dans une plage assez grande de leur caractéristique $V_s = f(V_e)$ pour augmenter

le rendement de la chaîne d'amplification, et donc dans des portions non linéaires de cette caractéristique, la tension de sortie de la chaîne d'amplification n'est plus alors rigoureusement proportionnelle à la tension d'entrée. Il apparaît des termes fonction du carré de la tension d'entrée, les termes fonction du cube de cette même tension, etc... Le calcul développé des différentes composantes du signal de sortie montre que les termes fonction du cube de la tension d'entrée font apparaître des signaux aux pulsations des fréquences sous-porteuses constituant le signal d'entrée, contrairement aux termes fonction du carré de la tension d'entrée qui eux ne font pas apparaître de tels signaux. Dans les composantes à l'une des porteuses d'entrée, l'une est le résultat de l'intermodulation c'est-à-dire un signal de distorsion dû à la modulation de la sous-porteuse elle-même, l'autre est un signal parasite créé par l'autre porteuse. Ainsi, pour un signal de télévision amplifié en voie commune, le signal son étant $u_1 = P_a(t) \cos \cdot \omega_a(t)$, le signal image étant $u_2 = P_i(t) \cos \cdot \omega_i(t)$, si $u_e$ est la somme de ces deux tensions et que la tension de sortie $u_s$ de la chaîne d'amplification est égale à $k_1 u_e + k_2 u_e^2 + k_3 u_e^3$, cette tension de sortie s'exprime en fonction des composantes image et son à l'entrée de la manière suivante :

$$u_s = k_1 P_a \cos \cdot \omega_a (t)$$
$$+ k_1 P_i \cos \cdot \omega_i (t)$$
$$+ (3/4) k_3 P_a (P_a^2 + 2P_i)^2 \cos \cdot \omega_a(t) \quad .$$
$$+ (3/4) k_3 P_i (2P_a^2 + P_i)^2 \cos \cdot \omega_i(t)$$
$$+ \ldots$$

Pour réaliser la correction d'intermodulation et de transmodulation simultanément, pour toute la plage de puissance des porteuses, le dispositif de correction comporte, pour la correction de chaque porteuse un système de filtrage des composantes à la fréquence de cette porteuse, suivi d'un atténuateur de coefficient égal à la partie du gain de la chaîne d'amplification indépendant du signal d'entrée, qui traite le signal de sortie de la chaîne d'amplification. Ce signal est divisé par le signal d'entrée de la chaîne d'amplification également après détection, le signal de sortie du diviseur fournissant un signal de précorrection appliqué à l'entrée de commande d'un atténuateur ajustable recevant le signal de la voie correspondante avant sommation avec le signal de l'autre voie.

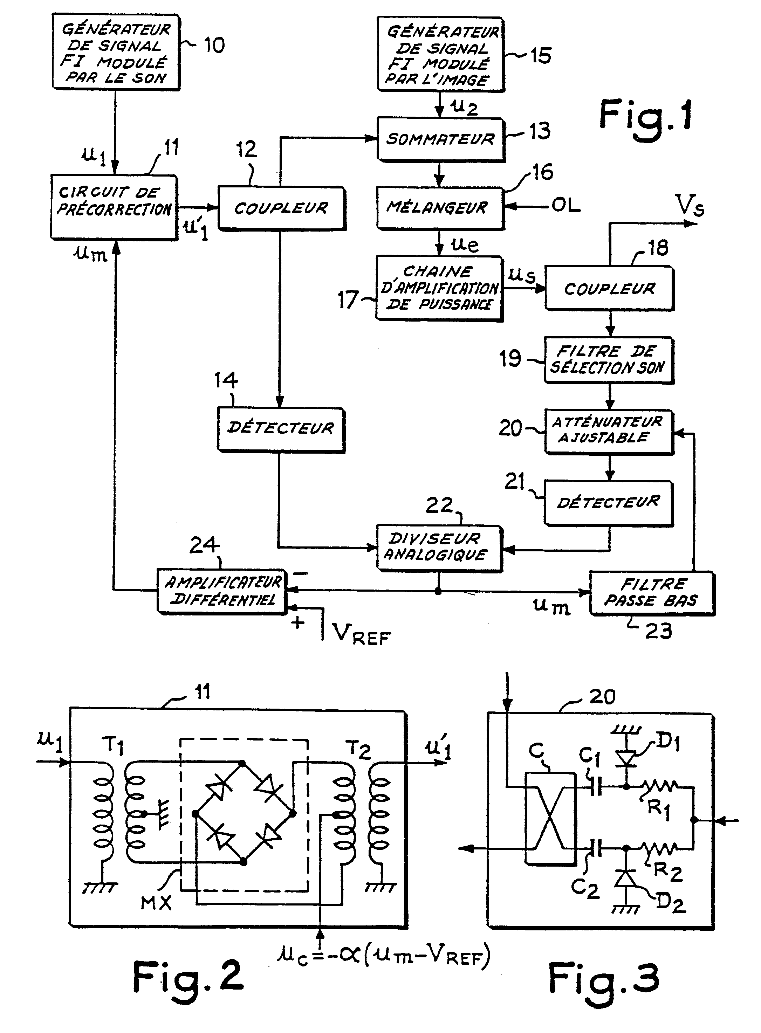

La figure 1 est le schéma synoptique du dispositif de correction automatique suivant l'invention pour la correction de l'une des porteuses. Pour la correction de l'autre porteuse une voie analogue doit être prévue comme il sera indiqué ci-après.

Sur la figure 1, un générateur de signal à fréquence intermédiaire modulé par le son, 10, est représenté. Sa sortie délivre le signal en fréquence intermédiaire, modulé en amplitude par le signal audiofréquence, soit $u_1$. La sortie de ce générateur est reliée à l'entrée de signal d'un circuit de précorrection 11 dont la sortie est reliée à l'entrée d'un coupleur 12 qui transmet la plus grande partie du signal d'entrée à la première entrée d'un sommateur 13, et une fraction $u_1/K$ de ce signal dans une voie de dérivation, à l'entrée d'un détecteur de modulation d'amplitude 14.

Un générateur de signal à fréquence intermédiaire modulé par l'image 15 à sa sortie reliée à la seconde entrée du sommateur 13 et fournit le signal à fréquence intermédiaire modulé en amplitude par le signal vidéo. La sortie du sommateur fournit donc un signal composite qui est alors transposé en radiofréquence, c'est-à-dire à la fréquence d'émission, dans un mélangeur 16 ayant une entrée d'oscillateur local à la fréquence d'émission, OL. La sortie de ce mélangeur est reliée à l'entrée de la chaîne d'amplification de puissance 17 qui reçoit donc le signal composite à la fréquence d'émission, $u_e$. Le signal de sortie de la chaîne d'amplification de puissance $u_s$ est appliqué à l'entrée d'un coupleur 18 qui en transmet la plus grande partie à la sortie en vue de son émission, et qui en prélève une fraction $u_s/K$ dans une seconde voie en dérivation dans le but de réaliser la correction automatique de distorsion. La sortie de dérivation du coupleur 18 est reliée à l'entrée d'un filtre de sélection de la porteuse son en radiofréquence, 19 ; la sortie de ce filtre est reliée à l'entrée d'un atténuateur ajustable 20 dont la sortie est reliée à l'entrée d'un détecteur de modulation d'amplitude 21.

Les sorties des détecteurs 14 et 21 sont reliées aux entrées d'un diviseur analogique 22 dont la sortie est couplée d'une part à l'entrée de commande du circuit de précorrection 11, pour la précorrection de la distorsion par l'intermédiaire d'un amplificateur différentiel 24, d'autre part, à l'entrée de commande de l'atténuateur ajustable 20, par l'intermédiaire d'un filtre passe-bas 23, cette atténuateur 20 étant prévu pour annuler les variations lentes de la partie du gain de la chaîne d'amplification de puissance indépendante de la tension d'entrée, en faisant varier de la même manière l'atténuation de l'atténuateur 20. Ces variations lentes peuvent être fonction de la température ou peuvent être occasionnées par le vieillissement des composants.

Ainsi, à la sortie du diviseur analogique rapide 22, la tension $u_m$ est composée d'une tension continue, qui sera annulée dans la boucle de commande du circuit de précorrection 11, d'un signal caractéristique de l'intermodulation son proportionnel à $(3/4) (k_3/k_1) P_a^2$, et d'un signal caractéristique de la transmodulation sur la porteuse son créée par la porteuse image proportionnel à $(3/2) (k_3/k_1) P_i^2$. L'amplificateur différentiel 24 permet d'inverser cette tension, d'annuler sa composante continue indépendante du signal de modulation $P_a(t)$ au moyen d'une tension de référence $V_{REF}$, et d'ajuster le coefficient d'efficacité de la correction. Il fournit donc le signal de commande de précorrection, appliqué au circuit de précorrection des composantes de distorsion son qui commande une variation du coefficient d'atténuation du circuit de correction en fonction de la tension d'entrée inverse de celle du gain de la chaîne d'amplification. Le circuit de précorrection ne doit pas distordre le signal à transmettre, ces signaux étant en général des signaux à fort niveau. De plus, il doit avoir un loi de commande linéaire et un temps de réponse très court puisqu'il doit suivre les composantes de modulation. Enfin, il ne doit surtout pas intégrer la tension de commande appliquée sur son entrée. En conséquence, dans un mode de réalisation préféré de l'invention, le circuit de précorrection 11 est un atténuateur ajustable réalisé à partir d'un mélangeur à diodes PIN rapides.

Ce mode de réalisation de l'atténuateur ajustable 11 est représenté sur la figure 2. Il comporte un transformateur d'entrée $T_1$ sur le primaire duquel est appliqué le signal à fréquence intermédiaire modulé en amplitude par le son, $u_1$. Le point milieu du secondaire du transformateur $T_1$ est relié à la masse tandis que les extrémités de ce secondaire sont reliées à deux bornes opposées du mélangeur rapide à diodes PIN, MX. Les deux autres bornes opposées du mélangeur à diodes sont reliées aux extrémités du primaire d'un second transformateur $T_2$ dont le point milieu reçoit le signal de commande de précorrection $u_c = - (\alpha\ u_m - V_{REF})$, $\alpha$ étant le coefficient d'efficacité de la correction. Le secondaire du transformateur $T_2$ fournit le signal à fréquence intermédiaire, modulé en amplitude par le son, précorrigé pour compenser les distorsions qui seront introduites par la suite par la chaîne d'amplification de puissance du fait des non-linéarités.

Pour ce dispositif de correction automatique fonctionne convenablement, il est nécessaire que le temps de transfert de la chaîne d'amplification soit le plus faible possible. De même, dans le filtre de sélection des composantes à la fréquence d'émission du son, 19, (ou dans le filtre de sélection des composantes à la fréquence d'émission de l'image, dans le cas où la boucle concerne la correction de la porteuse image), il est nécessaire que le temps de transfert soit aussi faible que possible, ce filtre devant être en même temps très sélectif. Ce temps de transfert du filtre doit en tout état de cause rester inférieur à 100 ou 150 nanosecondes. En conséquence dans un mode de réalisation préféré de l'invention, le filtre de sélection 19 sera un filtre réjecteur des composantes à la fréquence porteuse image (ou son, dans le cas de la correction de la composante image). De plus, pour que le système fonctionne correctement, il importe que les détecteurs, 14 et 21, traitant respectivement le signal modulé avant et après l'amplification de puissance, soient aussi semblables que possible de façon que le diviseur analogique fasse apparaître des composantes de distorsion réelles.

L'atténuateur ajustable 20 est prévu comme indiqué ci-dessus pour tenir compte de l'évolution de la composante du gain de la chaîne d'amplification de puissance, $k_1$, indépendante de la tension d'entrée. En effet, si ce gain évolue dans le temps ou en fonction de la température, et que l'atténuation par l'atténuateur 20 reste fixe et égale à $1/k_1$, le montage ne sera plus équilibré. Le coefficient $1/k_1$ appliqué au signal de sortie de la chaîne d'amplification de puissance par l'atténuateur 20 est donc asservi aux variations de $k_1$ dans la chaîne d'amplification. Cet asservissement prend comme base la tension continue à la sortie du diviseur analogique 22. Pour cela le signal de sortie du diviseur analogique $u_m$ est filtré dans le filtre passe-bas 23 afin d'éliminer toutes les composantes dues à la modulation. Le signal de sortie du filtre passe-bas 23 est donc le signal de commande de l'atténuateur ajustable 20. Ainsi les défauts « rapides » fonction de la modulation du signal d'entrée sont supprimés quelles soient les variations « lentes » du gain de la chaîne d'amplification, en conservant une qualité constante, la correction étant indépendante du niveau de sortie réel. Pour que le système de correction automatique continue à fonctionner même lorsqu'une forte baisse de niveau est détectée dans la chaîne d'amplification, il est nécessaire que la boucle de commande de l'atténuateur ajustable ait une dynamique suffisante. En conséquence, l'atténuateur ajustable 20 est, dans un mode de réalisation préféré de l'invention, constitué d'un coupleur 3 décibels, dans lequel on fait varier le coefficient de réflexion par une commande à diodes PIN. Un mode de réalisation de cet atténuateur est représenté sur la figure 3. La sortie du filtre de sélection son 29 est reliée au premier accès d'un coupleur 3dB C, dont un deuxième accès constitue la sortie de l'atténuateur. Les troisième et quatrième accès sont reliés à l'entrée de commande par l'intermédiaire de condensateurs $C_1$, $C_2$ respectivement et de résistances $R_1$ et $R_2$ respectivement, les points communs aux résistances et capacités étant reliés à la masse par l'intermédiaire de diodes PIN, $D_1$ et $D_2$.

En ce qui concerne le diviseur analogique 22, il n'existe pas actuellement de tels diviseurs suffisamment rapides pour travailler dans toute la bande du signal vidéo. En conséquence, le diviseur analogique est réalisé au moyen d'un multiplicateur monté dans la boucle de contre-réaction d'un amplificateur opérationnel ayant une bande de transfert suffisamment grande pour que le signal vidéo soit transmis.

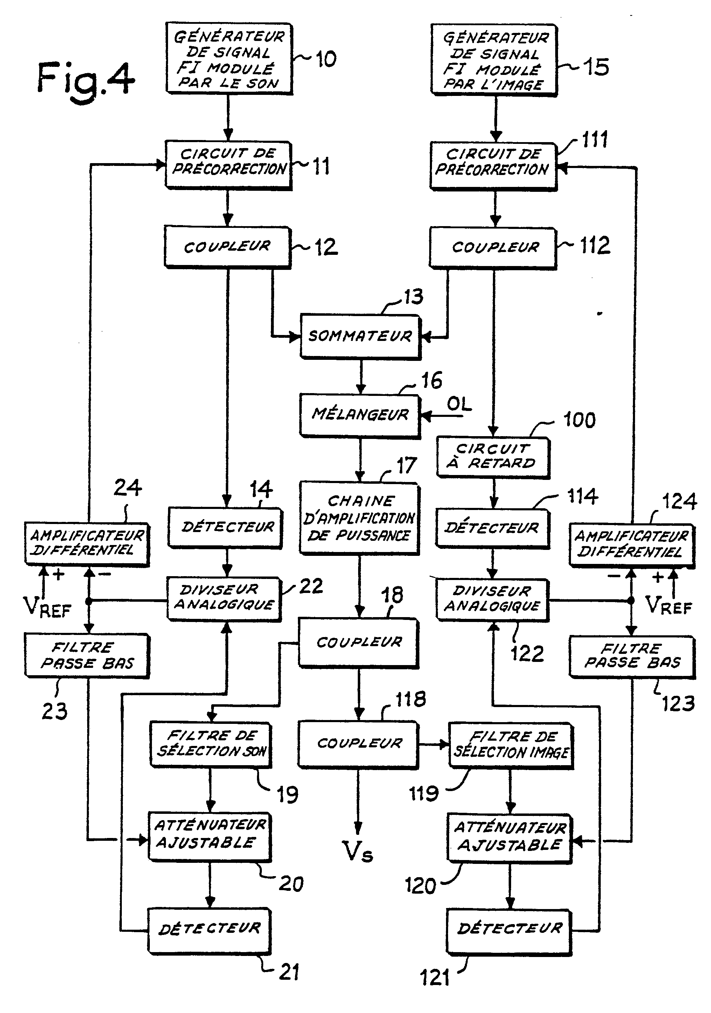

La figure 4 représente un dispositif de précorrection permettant de corriger également les distorsions sur la porteuse image. Les mêmes éléments que sur la figure 1 ont été désignés par les mêmes repères et des éléments analogues se rapportant au traitement de la porteuse image ont été désignés par les repères augmentés de 100.

Pour réaliser dans le même montage la correction des distorsions de la composante image, un circuit de précorrection 111 et un coupleur 112 sont placés en série entre la sortie du générateur de signal modulé par l'image, 15, et l'entrée correspondante du sommateur 13. La seconde sortie du coupleur est reliée à un dispositif de détection de modulation image, 114, tandis qu'un autre coupleur 118 est prévu à la sortie de la chaîne d'amplification de puissance pour alimenter la boucle de détection des distorsions image qui comporte alors un filtre de sélection image 119 accordé sur la fréquence porteuse d'émission de la composante d'image, suivi d'un atténuateur ajustable 120 et d'un détecteur de modulation d'amplitude 121 ; de la même manière que précédemment la sortie du détecteur de signal image avant amplification et la sortie de la chaîne de détection du signal image après amplification sont reliées aux entrées d'un diviseur analogique 122 dont la sortie commande le circuit de précorrection 111 placé dans la voie image avant la réunion des composantes image et son. Mais en plus, pour le traitement des composantes à la fréquence image, il est nécessaire d'introduire dans la voie de détection du signal avant sommation un circuit à retard 100, pour compenser le retard introduit dans la chaîne d'amplification de puissance, retard généralement fonction de la fréquence de l'émetteur. Pour obtenir un circuit de correction automatique standard, il est utile de prévoir une ligne à retard fixe et une ligne à retard variable pour ajuster le retard introduit dans cette voie à la fréquence de l'émetteur.

L'invention n'est pas limitée aux modes de réalisation décrits et représentés. En particulier, il a été supposé dans le schéma de la figure 1 que la sommation des deux composantes était réalisée à partir des composantes en fréquence intermédiaire, et dans ce cas la détection de la modulation de la composante son avant sommation est réalisée en fréquence intermédiaire tandis que la détection de la modulation de la composante son après sommation est réalisée en VHF à la fréquence d'émission. Il est évident que si la sommation a lieu en VHF, les deux détections peuvent être réalisées toutes deux en VHF, ou comme dans le mode de réalisation décrit, la détection de signal avant amplification peut être réalisée en amont, dans la voie en fréquence intermédiaire. De plus, le dispositif de correction décrit ci-dessus a été axé sur la correction de la transmodulation et de l'intermodulation simultanément, dans un émetteur ou un réémetteur en voie commune, mais ces dispositifs de correction automatique s'appliquent tout aussi bien à la correction d'intermodulation de l'une des composantes seulement lorsque ces composantes sont amplifiées séparément, la distorsion de non-linéarité étant alors seulement de l'intermodulation. Dans ce cas il n'est d'ailleurs pas utile de prévoir un filtre à la sortie de la chaîne d'amplification.

**Revendications**

1. Dispositif de précorrection de non-linéarités dues à la transmodulation dans une chaîne (17) d'amplification de puissance en voie commune de plusieurs porteuses modulées en amplitude, comportant deux voies en dérivation respectivement connectées en amont et en aval de la chaîne d'amplification pour prélever une partie du signal transmis, chacune comportant un circuit de détection (14, 21) recevant le signal prélevé, la voie en dérivation branchée à la sortie de la chaîne d'amplification comportant en outre un atténuateur (20) ayant un coefficient d'atténuation égal à la partie du gain de la chaîne indépendante du signal d'entrée, caractérisé en ce que la voie en dérivation branchée à la sortie de la chaîne d'amplification en voie commune comporte en outre un circuit de filtrage (19) de la porteuse à corriger, la voie de dérivation en amont de la chaîne d'amplification étant branchée dans la voie de transmission de cette même porteuse, avant sommation des composantes à amplifier en voie commune et en ce que les sorties des voies en dérivation sont reliées aux entrées d'un diviseur analogique (22) dont la sortie est couplée à l'entrée de commande d'un circuit de précorrection (11) à atténuation ajustable, ce circuit de précorrection étant placé en amont de la dérivation précédant la chaîne d'amplification.

2. Dispositif selon la revendication 1 pour la correction des transmodulations, d'une part de la porteuse image sur la porteuse son et d'autre part de la porteuse son sur la porteuse image dans une chaîne d'amplification (17) en voie commune des composantes vidéo et audio d'un signal de télévision, caractérisé en ce qu'il comporte deux circuits de précorrection (11, 111) respectivement placés dans les voies de transmission image et son avant addition des composantes, deux voies en dérivation respectivement connectées entre le circuit de précorrection correspondant et la chaîne d'amplification, et deux voies de dérivation connectées à la sortie de la chaîne d'amplification, l'une comportant un circuit de filtrage (19) de la porteuse son et l'autre comportant un circuit de filtrage de la porteuse image (119).

3. Dispositif selon l'une quelconque des revendications précédentes, caractérisé en ce que pour la précorrection de non-linéarités sur la porteuse image d'un signal composite de télévision, la voie en dérivation correspondante située en amont de la chaîne d'amplification comporte en plus du circuit de détection (114) un circuit à retard (100) ajusté en fonction de la fréquence d'émission.

4. Dispositif selon l'une quelconque des revendications 1 à 3, caractérisé en ce que le circuit de précorrection (11) est un circuit atténuateur ajustable à diodes PIN.

5. Dispositif selon la revendication 1, caractérisé en ce que l'atténuateur (20) situé dans la voie de dérivation de sortie est un atténuateur ajustable commandé par les variations lentes de la composante continue du signal de sortie du diviseur (22), le dispositif comportant à cet effet un circuit de filtrage passe-bas (23) reliant la sortie du diviseur (22) à l'entrée de commande de cette atténuateur ajustable (20).

6. Application du dispositif de précorrection de non-linéarités selon l'une quelconque des revendications précédentes à un émetteur de télévision.

**Claims**

1. Device for the precorrection of non-linearities due to the cross modulation in power amplification chain (17) shared by a plurality of amplitude modulated carriers, comprising two derived paths respectively connected upstream and downstream from the amplification chain to derive a portion of the transmitted signal, each comprising a detection circuit (14, 21) receiving the derived signal, the derived path branched from the output of the amplification chain further comprising an attenuator (20) having a coefficient of attenuation equal to the portion of the gain of the chain which is independent of the input signal, characterized in that the derived path branched from the output of the shared amplification chain further comprises a circuit (19) for filtering the carrier to be corrected, the derived path upstream of the amplification chain being branched in the transmission chain of this same carrier prior to the summing of the components to be amplified in common, and that the outputs of an analog divider (22) the output of which is coupled to the control input of a precorrection circuit (11) having an adjustable attenuation, this precorrection circuit being located upstream of the derivation preceding the amplification chain.

2. Device according to claim 1 for the correction of cross modulations, on the one hand, of the sound carrier by the image carrier and, on the other hand, of the image carrier by the sound carrier in an amplification chain (17) shared by the video and audio components of a television signal, characterized in that it comprises two precorrection circuits (11, 111) respectively located in the image and sound transmission paths prior to the addition of the components, two derived paths respectively connected between the corresponding precorrection circuit and the amplification chain, and two derived paths connected to the output of the amplification chain, one comprising a circuit (19) for filtering the sound carrier and the other comprising a circuit .(119) for filtering the image carrier.

3. Device according to any of the preceding claims, characterized in that, for the precorrection of non-linearities in the image carrier of a composite television signal, the corresponding derived path located upstream of the amplification chain comprises, in addition to the detection circuit (114), a delay circuit (100) adjusted as a function of the transmission frequency.

4. Device according to any of claims 1 to 3, characterized in that the precorrection circuit (11) is an adjustable PIN diode attenuator.

5. Device according to claim 1, characterized in that the attenuator (20) located in the derived output path is an adjustable attenuator controlled by the slow variations of the continuous component of the output signal of the divider (22), the device comprising to this end a low-pass filter circuit (23) connecting the output of the divider (22) to the control input of this adjustable attenuator.

6. Use of the non-linearities precorrection device according to any of the preceding claims, in a television transmitter.

**Patentansprüche**

1. Vorrichtung zur Vorkorrektur von Nichtlinearitäten, die auf der Kreuzmodulation in einer Leistungsverstärkerkette (17) mit gemeinsamen Kanal mehrerer amplitudenmodulierter Trägerschwingungen beruhen, mit zwei abgezweigten Kanälen, die vor bzw. hinter der Verstärkerkette angeschlossen sind, um einen Teil des übertragenen Signals abzugreifen, jeweils mit einer Detektionsschaltung (14, 21), welche das abgriffene Signal empfängt, wobei der an Ausgang der Verstärkerkette abgezweigte Kanal weiterhin ein Dämpfungsglied (20) umfaßt, dessen Däpfungskoeffizient gleich dem Teil des Verstärkungsfaktors der Verstärkerkettes ist, welcher unabhängig von dem Eingangssignal ist, dadurch gekennzeichnet, daß der vom Ausgang der Verstärkerkette mit gemeinsamem"Kanal abgezweigte Kanal weiterhin eine Filterschaltung (19) zum Filern der zu korrigierenden Trägerschwingung umfaßt, wobei der vor der Verstärkerkette abgezweigte Kanal in den Übertragungskanal dieser selben Trägerschwingung einmündet, bevor die Summierung der mit gemeinsamem Kanal zu verstärkenden Komponenten erfolgt, und daß die Ausgänge der abgezweigten Kanäle mit den Eingängen eines analogen Teilers (22) verbunden sind, dessen Ausgang an den Steuereingang einer Vorkorrekturschaltung (11) mit einstellbarer Dämpfung angeschlossen ist, wobei diese Vorkorrekturschaltung der Abzweigung vorgeschaltet ist, welche der Verstärkerkette vorausgeht.

2. Vorrichtung nach Anspruch 1 zur Korrektur von Kreuzmodulationen, einerseits des Tonträgers durch den Bildträger und andererseits des Bildträgers durch den Tonträger in einer Verstärkerkette (17) mit gemeinsamem Kanal der Video- und Tonkomponenten eines Fernsehsignals, dadurch gekennzeichnet, daß sie zwei Vorkorrekturschaltungen (11, 111) umfaßt, von denen die eine im Bildübertragungskanal und die andere im Tonübertragungskanal vor Addition der Komponenten angeordnet ist, zwei abgezweigte Kanäle umfaßt, die jeweils zwischen die entsprechende Vorkorrekturschaltung und die Verstärkerkette geschaltet sind, und zwei abgezweigte Kanäle umfaßt, welche an den Ausgang der Verstärkerkette angeschlossen sind, wobei einer von ihnen eine Filterschaltung (19) zum Filtern des Tonträgers und der andere eine Filterschaltung zum Filtern des Bildträgers (119) enthält.

3. Vorrichtung nach einem der vorstehenden Ansprüche, dadurch gekennzeichnet, daß zur Vorkorrektur von Nichtlinearitäten im Bildträger eines zusammengesetzten Fernsehsignals der entsprechende abgezweigte Kanal, der vor der Verstärkerkette liegt, ferner zusätzlich zur Detektionsschaltung (114) eine Verzögerungsschaltung (100) umfaßt, die in Abhängigkeit von der Sendefrequenz eingestellt ist.

4. Vorrichtung nach einem der Ansprüche 1 bis 3, dadurch gekennzeichnet, daß die Vorkorrekturschaltung (11) eine einstellbare Dämpfungsschaltung mit PIN-Dioden ist.

5. Vorrichtung nach Anspruch 1, dadurch gekennzeichnet, daß das Dämpfungsglied (20), welches in dem abgezweigten Ausgangskanal liegt, ein einstellbares Dämpfungsglied ist, das durch langsame Änderungen der Gleichkomponente des Ausgangssignals des Teilers (22) gesteuert wird, wobei die Vorrichtung zu diesem Zweck eine Tiefpaßfilterschaltung (23) aufweist, welche den Ausgang des Teilers (22) mit dem Steuereingang dieses einstellbaren Dämpfungsgliedes (20) verbindet.

6. Verwendung der Vorrichtung zur Vorkorrektur von Nichtlinearitäten nach einem der Vorstehenden Ansprüche bei einem Fernsehsender.

**Fig.1**

GÉNÉRATEUR DE SIGNAL FI MODULÉ PAR LE SON — 10

GÉNÉRATEUR DE SIGNAL FI MODULÉ PAR L'IMAGE — 15

$u_1$

$u_2$

SOMMATEUR — 13

CIRCUIT DE PRÉCORRECTION — 11

$u'_1$

$u_m$

COUPLEUR — 12

MÉLANGEUR — 16 ← OL

$V_S$

$u_e$

CHAINE D'AMPLIFICATION DE PUISSANCE — 17

$u_s$

COUPLEUR — 18

FILTRE DE SÉLECTION SON — 19

DÉTECTEUR — 14

ATTÉNUATEUR AJUSTABLE — 20

DÉTECTEUR — 21

DIVISEUR ANALOGIQUE — 22

AMPLIFICATEUR DIFFÉRENTIEL — 24

FILTRE PASSE BAS — 23

$u_m$

$V_{REF}$

**Fig.2**

$u_1$  $T_1$  $T_2$  $u'_1$

MX

$u_c = -\alpha(u_m - V_{REF})$

**Fig.3**

C  $C_1$  $D_1$  $R_1$  $C_2$  $R_2$  $D_2$

20

# Fig.4